Europäisches Patentamt

European Patent Office

Office européen des brevets

(11) Veröffentlichungsnummer: **0 340 773**
**A2**

(12) **EUROPÄISCHE PATENTANMELDUNG**

(21) Anmeldenummer: **89108069.9**

(22) Anmeldetag: **04.05.89**

(51) Int. Cl.⁴: **H05K 9/00**

(30) Priorität: **06.05.88 DE 3815517**

(43) Veröffentlichungstag der Anmeldung:
**08.11.89 Patentblatt 89/45**

(84) Benannte Vertragsstaaten:
**AT BE CH DE ES FR GB IT LI NL SE**

(71) Anmelder: **Standard Elektrik Lorenz Aktiengesellschaft**
**Lorenzstrasse 10**
**D-7000 Stuttgart 40(DE)**

(84) **DE**

Anmelder: **ALCATEL N.V.**
**Strawinskylaan 341 (World Trade Center)**
**NL-1077 XX Amsterdam(NL)**

(84) **BE CH ES FR GB IT LI NL SE AT**

(72) Erfinder: **Stapelfeldt, Rolf**
**Goethering 53**
**D-7537 Remchingen 2(DE)**

(74) Vertreter: **Beck-Seyffer, Karl Heinz, Dipl.-Ing. et al**
**Standard Elektrik Lorenz AG Patent- und Lizenzwesen Postfach 30 09 29**
**D-7000 Stuttgart 30(DE)**

(54) **Dichtung für ein elektromagnetische Strahlung abschirmendes Gehäuse.**

(57) Um eine einwandfreie HF-Abschirmung von tragbaren Funkgeräten zu erreichen, muß für eine elektrisch leitende Verbindung zwischen einem Gehäuse-Unterteil 3 und einem -Oberteil 2 gesorgt werden. Dies wird bislang dadurch erreicht, daß metallisierte Dichtungen verwendet werden. Diese müssen an metallisch blanken Gehäuserändern anliegen, da sonst die Abschirmwirkung stark beeinträchtigt würde. Die Dichtung und die Gehäuseränder sind aber den Umwelteinflüssen ausgesetzt. Dabei bilden sich elektrochemische Elemente, die eine schnelle Korrosion der Gehäuseteile bewirken. Die Idee der Erfindung ist es, die Dichtung 1 zu versehen mit einem nichtleitendem Teil 4 aus einem gummielastischen Werkstoff, der an oberflächengeschützten, außenliegenden Gehäuseteilen 10, 11 anliegt, und einen leitenden Teil 5, der an metallisch blanken, innenliegenden Gehäuseteilen 16, 17 anliegt. Diese blanken Gehäuseteile 16, 17 werden durch den nichtleitenden Teil 4 vor der Korrosion geschützt.

FIG.1

## Dichtung für ein elektromagnetische Strahlung abschirmendes Gehäuse

Die Erfindung betrifft eine Dichtung für ein elektromagnetische Strahlung abschirmendes Gehäuse, durch die einzelne Gehäuseteile leitend miteinander verbunden werden.

Geräte der Nachrichtentechnik, z.B. tragbare Funkgeräte, müssen hohe Anforderungen an die EMV und EMP (elektromagnetische Verträglichkeit bzw. Verträglichkeit gegen elektromagnetische oder sonstige Felder mit hoher Impulsleistung) erfüllen. Zum einen ist in hohem Maße mit äußeren Störquellen zu rechnen, so daß die aufwendigen und empfindlichen elektronischen Schaltungsbestandteile solcher Geräte wirksam gegen äußere Störstrahlungen geschützt werden müssen. Zum anderen erzeugen diese Geräte aufgrund zunehmender Integration und steigender Taktfrequenzen selbst hohe Störstrahlungen, die nicht in die Umwelt gelangen dürfen. Eine wirksame Möglichkeit, die Anforderungen an die EMV zu erfüllen, ist bekanntlich, die Geräteschaltungen durch ein metallisches Gehäuse abzuschirmen. Ein solches Gehäuse weist aber immer Fugen auf, z.B. zwischen Gehäusewänden und Deckel, und Öffnungen zum Anschließen der Bedienungs- und Anzeigeeinrichtungen. Diese Spalten und Öffnungen müssen so verschlossen werden, daß die Abschirmwirkung des Gehäuses gewährleistet bleibt.

Bekannt ist es, zu diesem Zweck Dichtungen zu verwenden, die sowohl gummielastisch als auch elektrisch leitend sind, z.B. in dem sie aus mit feinstem Metallpulver gefüllten Silikonen bestehen oder einen Kern aus einem elastischen Werkstoff und eine äußere leitfähige Hülle aufweisen (EP 0 252 203 A2).

Durch eine damit erreichbare elektrische Verbindung zwischen den verschiedenen Gehäuseteilen wird eine gute HF-Abschirmwirkung erreicht. Dazu müssen aber die abzudichtenden Gehäuseteile an den Stellen, an denen die Dichtung aufliegt, metallisch blank sein. Eine Lackierung an dieser Stelle würde die Abschirmwirkung erheblich verschlechtern.

Tragbare Fernmeldegeräte sind häufig aber auch anderen Umgebungseinwirkungen unterworfen. Sie müssen deshalb auch gegen ein Eindringen von Feuchtigkeit und von unter Druck stehenden Gasen und Flüssigkeiten geschützt werden. Auch hier sind häufig hohe Mindestanforderungen zu erfüllen, die aber mit den EMV-Anforderungen nicht immer ohne Schwierigkeiten in Einklang zu bringen sind. Der Metallgehalt oder die metallisierte Oberfläche der Dichtung bildet zusammen mit den metallisch blanken Auflageoberflächen in dem Gehäuse gefährliche Angriffspunkte für die Korrosion. In Verbindung mit Feuchtigkeit und dem Säuregehalt der umgebenden Atmosphäre bilden sich hier elektrochemische Elemente, die ein schnelles korrodieren und oxydieren der Gehäuseteile bewirken. Dadurch kann in kurzer Zeit die Abschirmwirkung und Druckdichtigkeit des Gehäuses verlorengehen. Ein Oberflächenschutz des Gehäuses an den gefährdeten Stellen würde andererseits, wie bereits erwähnt, die Abschirmwirkung stark herabsetzen.

Der Erfindung liegt die Aufgabe zugrunde, eine Dichtung für elektrische und elektronische Geräte zu schaffen, die die Geräte sowohl gegen ein Eindringen von Gasen oder Flüssigkeit abdichtet als auch elektromagnetische Störstrahlungen abschirmt, die aber auch die Korrosion wirksam verhindert.

Diese Aufgabe wird erfindungsgemäß durch eine Dichtung der eingangs genannten Art gelöst, die aufweist:

a) einen nichtleitenden Teil aus einem gummielatischen Werkstoff, der zur Anlage an oberflächengeschützen, außenliegenden Gehäuseteilen bestimmt ist, und

b) einen leitenden Teil, der zur Anlage an metallisch blanken, innenliegenden Gehäuseteilen bestimmt ist.

Vorteilhafte Weiterbildungen der Erfindung sind den Unteransprüchen zu entnehmen.

Die Vorteile der Erfindung liegen insbesondere darin, daß alle Gehäuseteile an den abzudichtenden Fugen in dem äußeren Bereich, der die mechanische Abdichtung gegen ein Eindringen von Flüssigkeiten und Gasen bewirkt, einwandfrei oberflächengeschützt, z.B. lackiert, werden können. Es verbleiben keine blanken Stellen, die aggressiven Umwelteinflüssen ausgesetzt sein könnten. Der innere Bereich hingegen, in dem die erfindungsgemäße Dichtung für eine einwandfreie elektrisch leitende Verbindung zwischen den Gehäuseteilen bewirkt, ist von den Umwelteinflüssen vollkommen getrennt. Eine Korrosion wird also auch hier einwandfrei verhindert.

Ausführungsbeispiele der Erfindung werden im folgenden anhand der Zeichnung erläutert. Es zeigen:

Fig. 1 eine eine Gehäusefuge abdichtende erfindungsgemäße Dichtung,

Fig. 2 ein zweites Beispiel einer erfindungsgemäßen Dichtung,

Fig. 3 den leitenden Teil der Dichtung nach Fig. 2,

Fig. 4 ein drittes Ausführungsbeispiel der Erfindung,

Fig. 5 ein viertes Ausführungsbeispiel der Erfindung,

Fig. 6 ein mit einer erfindungsgemäßen Dichtung zu versehendes Gehäuseunterteil, in der Draufsicht,

Fig. 7 eine für das Gehäuse gemäß Fig. 6 bestimmte Dichtung, und

Fig. 8 eine weitere erfindungsgemäße Dichtung in einer perspektivischen Teilansicht.

Eine erfindungsgemäße Dichtung 1 dichtet die Verbindung oder Fuge zwischen dem Oberteil 2 und dem Unterteil 3 eines Gehäuses ab, von dem in der Zeichnung ein Ausschnitt perspektivisch dargestellt ist. Die Dichtung 1 weist einen äußeren nichtleitenden Teil 4 und einen inneren elektrisch leitenden Teil 5 auf. Der äußere Teil 1 ist aus einem gummielatischen Werkstoff, z.B. aus einem elastomeren Kunststoff hergestellt. Der leitende Teil 5 ist aus einem metallischem Werkstoff, z.B. aus einer oberflächenbehandelten Kupfer-Beryllium-Legierung hergestellt, wie sie für bekannte Kontaktstreifen verwendet wird.

Der innere Teil 5 ist streifenförmig ausgebildet, mit seinem in der Zeichnung links liegenden Rand 6 ist er in den nichtleitenden Teil 4 eingebettet. Er weist Durchbrüche 7 auf, die von dem Werkstoff des nichtleitenden Teils 4 aufgefüllt sind und eine einwandfreie Verbindung zwischen den beiden Teilen 4 und 5 sichern. In seinem in der Zeichnung rechts liegenden Bereich weist der leitende Teil 5 eine ganze Reihe streifenförmiger Vorsprünge 8 auf, deren Abstand und Verschränkung so ist, daß eine einwandfreie elektrische Abschirmung gewährleistet ist, und die aufgrund ihrer elastischen Beweglichkeit auch an etwas ungenau bearbeiteten Gehäuserändern einwandfrei anliegen.

Zur Aufnahme der Dichtung 1, d.h. von deren äußerem Teil 4, weist das Gehäuse-Oberteil 2 eine Nut 10 und das Gehäuse-Unterteil 3 eine Ausnehmung 11 auf. Die äußeren Oberflächen des Oberteils 2 und den Unterteils 3 sowie der Nut 10 und der Ausnehmung 11 sind oberflächengeschützt, d.h. mit Grund- und Lackschichten 12, 13 versehen, die aus zeichnerischen Gründen stärker dargestellt sind, als sie es tatsächlich sind. Diese Oberflächenschutzschichten 12, 13 reichen bis zu den inneren Rändern 14 und 15 der Nut 10 bzw. der Ausnehmung 11. Daran anschließende, bis zur Gehäuseinnenseite reichende streifenförmige Randflächen 16 und 17 sind metallisch blank und nicht mit einer Lack- oder Farbschicht versehen. Sie weisen somit einen geringen Kontaktwiderstand auf und ergeben, wie bereits erwähnt, zusammen mit dem leitenden Teil 5 der Dichtung 1 einen einwandfrei hochfrequente Signale abschirmenden Gehäuseabschluß.

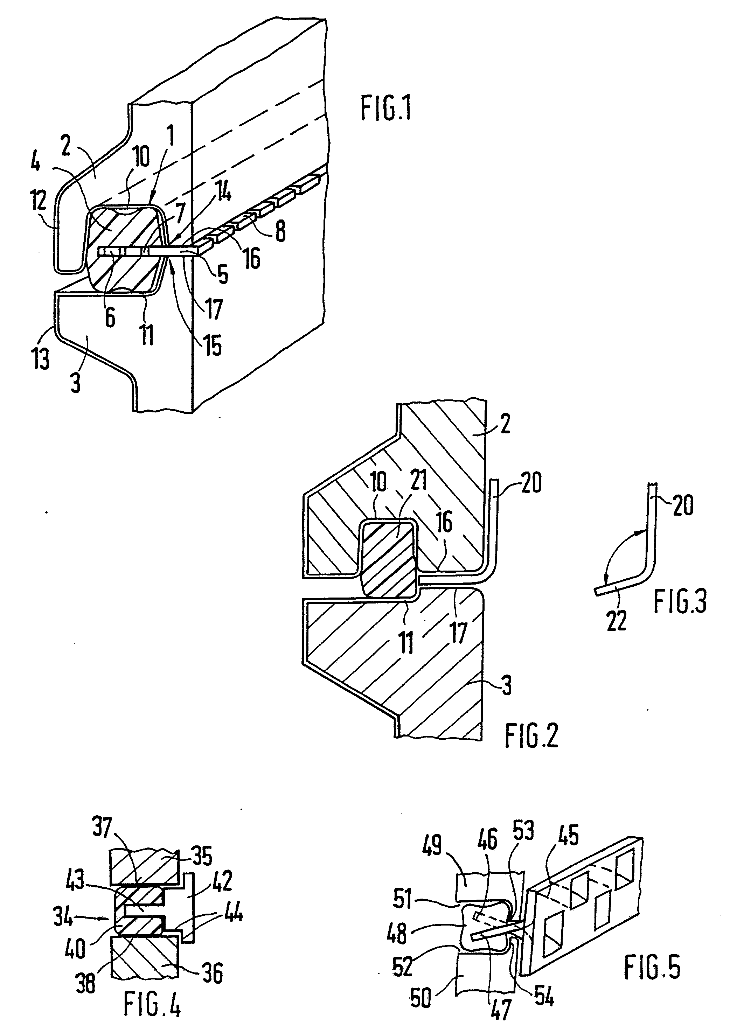

Bei dem aus den Fig. 2 und 3 ersichtlichen Ausführungsbeispiel der erfindungsgemäßen Dichtung, ist deren leitender Teil 20 nicht in deren nichtleitenden Teil eingebettet, die beiden Teile werden erst bei der Montage zusammengefügt. Der nichtleitende Teil 21 ist auch hier als strangförmiges Profil aus einem gummielastischen Dichtungsmaterial hergestellt, das in die Nut 10 eingelegt und zwischen dieser und der Ausnehmung 11 zusammengedrückt wird. Der leitende Teil 20 besteht aus einem Metallblechstreifen, der winkelförmig umgebogen ist. Seine beiden Schenkel bilden einen Winkel von etwa mehr als 90° (Fig. 3). Sein zur Gehäuseaußenseite hinweisender Schenkel 22 wird zwischen die metallisch blanken Randflächen 16, 17 eingespannt und dabei in einen etwa rechten Winkel umgebogen. Durch dieses Einspannen und die elastische Verformung des Schenkels 22 wird der leitende Teil 20 in seiner Lage fixiert. Da er außerdem in gutleitendem Kontakt mit dem Gehäuse-Oberteil 2 und dem Unterteil 3 steht, ist auch hier eine einwandfrei abelektromagnetische Abschirmung gesichert, während der nichtleitende Teil 21 den äußeren Druck, Feuchtigkeit und sonstige Umgebungseinflüsse abhält.

Eine aus Fig. 4 ersichtliche erfindungsgemäße Dichtung ist für einfacher gestaltete Abschirmgehäuse geeignet. Ein Gehäuse-Oberteil 35 und -Unterteil 36 weisen jeweils eine ebene Randfläche 37 bzw. 38 auf. Zwischen diese Randflächen 37, 38 ist ein nichtleitender Teil 40 in Form eines Strangprofils aus elastischem Werkstoff eingefügt. Ein leitender Teil 42 ist als Strangprofil aus Kunststoff ausgebildet, das mit einem streifenförmigen Vorsprung 43 in dem nichtleitendem Teil 40 eingebettet ist. An seinen äußeren Oberflächen ist der Teil 42 mit einer Metallisierungsschicht 44 versehen, die für die erforderliche elektrisch leitende Verbindung zwischen dem Oberteil 35 und dem Unterteil 36 des Gehäuses sorgt.

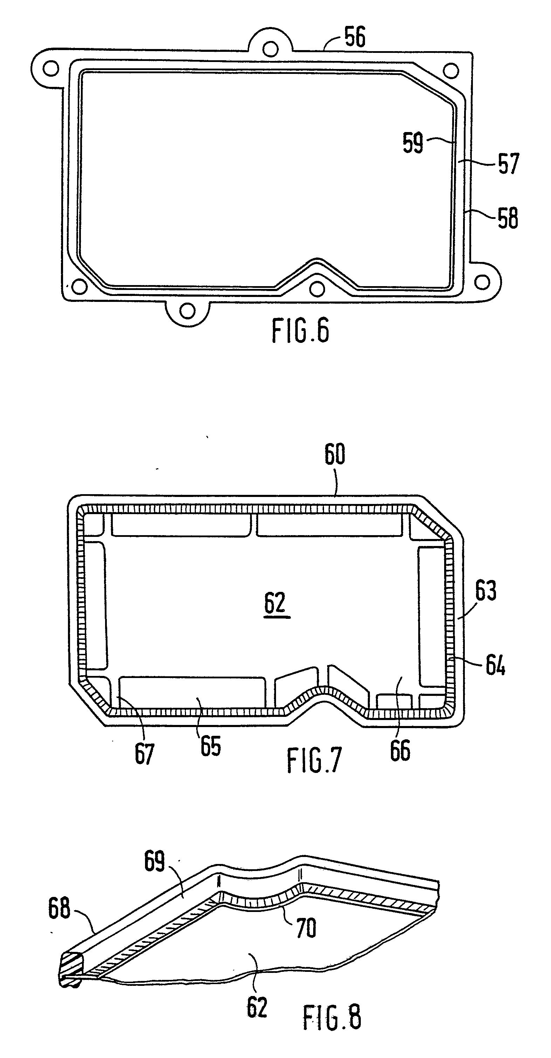

Bei der aus Fig. 5 ersichtlichen erfindungsgemäßen Dichtung ist der leitende Teil 45 als Metallstreifen ausgebildet, der an der Innenseite des abzudichtenden Gehäuses flach anliegt. Er weist eine Reihe von Blechnasen 46, 47 auf, die U-förmig aus dem Metallstreifen ausgestanzt und umgebogen sind. Diese Blechnasen 46, 47 sind gegeneinander verschränkt und ergeben somit einen guten Halt in dem nichtleitenden Teil 48 der Dichtung, in den sie eingebettet sind.

Das Oberteil 49 und das Unterteil 50 des Gehäuses sind mit je einem Absatz 51 bzw. 52 versehen, zwischen denen der nichtleitende Teil eingefügt ist. Die Absätze 51, 52 sind bis zu einer hinteren Abschlußkante 53 bzw. 54 oberflächengeschützt. Die sich daran nach innen anschließenden Ränder des Gehäuse-Oberteils 49 und -Unterteils 50 sind metallisch blank und haben somit guten elektrischen Kontakt zu dem leitenden Teil 45 der Dichtung.

Ein in der Draufsicht dargestelltes Gehäuse-Unterteil 56 (Fig. 6) weist aufgrund technischer Erfordernisse eine Kontur auf, die eine nicht ganz einfache Form der Dichtung zur Folge hat. Eine Nut 57, die zur Aufnahme des nichtleitenden Teil der Dichtung dient (diese wird anhand von Fig. 7 beschrieben), und eine äußere Randfläche 58 sind, wie die gesamte Gehäuse-Außenfläche, oberflächengeschützt. Eine innere Randfläche 59 ist metallisch blank, sie dient als "Kontaktrand", an dem in montiertem Zustand der leitende Teil der Dichtung anliegt.

Aufgrund der komplizierten Gestalt und der teilweise sehr kleinen Abmessungen erfindungsgemäßer Dichtungen, von denen die Dichtung 60 (Fig. 7) ein Beispiel ist, ist es zweckmäßig, eine Metallplatte 62 als Ätzteil herzustellen, auf deren äußeren Rand der nichtleitende Teil 63 der Dichtung in einem Pressvorgang aufgebracht wird. Den leitenden Teil der Dichtung 60 bildende Lamellen oder Kontaktfinger 64 sowie Aussparungen 65 werden durch einen Ätzvorgang hergestellt. Nach dem Ätzen verbleibt von der Metallplatte 62 ein Halteteil 66, das durch Haltestege 67 mit der Dichtung 60 verbunden ist. Zwischen den Haltestegen 67 und dem leitenden Teil der Dichtung 60 sind vorgeätzte Sollbruchstellen vorgesehen. Entlang dieser Stellen wird das Halteteil 66 vor dem Einbauen der Dichtung 60 herausgebrochen.

Ein Ausschnitt einer ebenfalls durch Ätzen einer Metallplatte 62 hergestellten Dichtung 68 mit aufgepreßtem nichtleitenden Teil 69 und aus einzelnen Lamellen gebildetem leitenden Teil 70 ist in Fig. 8 perspektivisch dargestellt.

## Ansprüche

1. Dichtung für ein elektromagnetische Strahlung abschirmendes Gehäuse, durch die einzelne Gehäuseteile leitend miteinander verbunden werden, **dadurch gekennzeichnet,** daß sie aufweist:

a) einen nichtleitenden Teil (4) aus einem gummielastischen Werkstoff, der zur Anlage an oberflächengeschützten, außenliegenden Gehäuseteilen (10, 11) bestimmt ist und

b) einen leitenden Teil (5), der zur Anlage an metallisch blanken, innenliegenden Gehäuseteilen (16, 17) bestimmt ist.

2. Dichtung nach Anspruch 1, dadurch gekennzeichnet, daß der leitende Teil (5) einen Befestigungsrand (6) aufweist, der in den nichtleitenden Teil (4) eingebettet ist.

3. Dichtung nach Anspruch 1, dadurch gekennzeichnet, daß der leitende Teil (5) mit streifenförmigen Vorsprüngen (8) versehen ist.

4. Dichtung nach Anspruch 1, dadurch gekennzeichnet, daß der leitende Teil (45) gegeneinander verschränkte Bereiche (46, 47) aufweist, durch die er in dem nichtleitenden Teil (48) verankert ist.

5. Dichtung nach Anspruch 1, dadurch gekennzeichnet, daß der leitende Teil (42) aus einem Kunststoff mit einer Oberflächenmetallisierung (44) hergestellt ist.

6. Dichtung nach Anspruch 1, dadurch gekennzeichnet, daß der leitende Teil aus einem sich an den nichtleitenden Teil (21) anschließenden, durch Klemmwirkung befestigten Metallstreifen (20) besteht.

7. Dichtung nach Anspruch 1, dadurch gekennzeichnet, daß der leitende Teil aus einem zwischen zwei nichtleitenden Teilen (23, 24) eingeklemmten Metallstreifen (30) besteht.

FIG.1

FIG.2

FIG.3

FIG.4

FIG.5

R. Stapelfeldt 15
4. 7. 88

FIG.6

FIG.7

FIG.8

R.Stapelfeldt 1s
4. 7. 88